# EUROPEAN PATENT APPLICATION

(11) **EP 4 567 776 A1**
(43) Date of publication of application: **11.06.2025**
(21) Application number: 22961059.7
(22) Date of filing: 26.09.2022
(51) Int. Cl.: G09F 9/302, H10K 59/00

(54) **DISPLAY DEVICE**

(71) Applicant: LG Electronics Inc., Yeongdeungpo-gu Seoul 07336 (KR)
(72) Inventor: LEE, Myoungku, Seoul 06772 (KR); MOON, Byungchun, Seoul 06772 (KR); LEE, Junhyeong, Seoul 06772 (KR); HUR, Hoon, Seoul 06772 (KR); SONG, Hyeoncheol, Seoul 06772 (KR)
(74) Representative: Vossius & Partner Patentanwälte Rechtsanwälte mbB
(86) International application number: PCT/KR2022/014347
(87) International publication number: WO 2024/071456

(57) **Abstract**

This display device comprises: a plurality of display modules disposed in up-down and left-right directions; and a filler filled between adjacent display modules, wherein the filler comprises binder resin, transmittance adjustment particles, and refractive index adjustment particles. The filler between the adjacent display modules may minimize optical distortion caused by a step difference of the plurality of display modules and a gap between the plurality of display modules.

## Description

### [Technical Field]

The present disclosure relates to a display device.

### [Background Art]

Recent display devices tend to have a plurality of display modules comprising display panels disposed together to form a large-sized screen.

A display device can implement a large-size screen by combining a plurality of display panels.

An example of a display device having a plurality of display panels disposed is disclosed in Korean Patent Publication No. 10-2016-0097599 A (published on August 18, 2016), which discloses a display module and a display device comprising the same, wherein the display device comprises a cabinet; and a display module having a plurality of LED panels disposed in the cabinet.

### [Disclosure]

### [Technical Problem]

An object of the present embodiment is to provide a display device capable of minimizing heterogeneity between adjacent display modules.

### [Technical Solution]

A display device according to the present disclosure comprises a plurality of display modules disposed in a vertical direction and a left and right direction; and a filler filled between adjacent display modules, in which the filler comprises a binder resin, transmittance-controlling particles, and refractive index-controlling particles.

The binder resin may comprise at least one of organic polysiloxane, polysiloxane block copolymer, polyester urethane, and wax.

A viscosity of the binder resin may be 50,000 cPs to 300,000 cPs.

The transmittance-controlling particles may comprise carbon black and color controlling particles (color pigments).

The refractive index-controlling particles may comprise silica and polystyrene beads.

The size of the silica may be 5 nm to 10 nm.

The size of the polystyrene beads may be 10 nm to 90 nm.

The content ratio of the transmittance-controlling particles may be 2% to 30%.

The content ratio of the refractive index-controlling particles may be 10% to 40%.

The display module may comprise a substrate; a plurality of LED chips disposed on the substrate; a coating layer covering the plurality of LED chips; and an optical film covering the coating layer.

A method for manufacturing a display device according to the present disclosure comprises applying a filler between adjacent display modules; filling with the filler using a tool; and wiping off the filler from the surfaces of the adjacent display modules; in which the filler may comprise a binder resin, transmittance-controlling particles, and refractive index-controlling particles.

The binder resin may comprise at least one of organic polysiloxane, polysiloxane block copolymer, polyester urethane, and wax.

The transmittance-controlling particles may comprise carbon black and color controlling particles (color pigments).

The refractive index-controlling particles may comprise silica and polystyrene beads.

### [Advantageous Effect]

According to the present embodiment, the filler between adjacent display modules can minimize optical distortion caused by steps between a plurality of display modules and gaps between a plurality of display modules.

In addition, the colors of a plurality of display modules can be matched by the transmittance controlling particles, and light scattered between a plurality of display modules can be absorbed.

Additionally, optical distortion due to refractive index can be minimized by refractive index-controlling particles.

### [Description of Drawings]

FIG. 1 is a block diagram illustrating the configuration of a display device according to the present embodiment;
FIG. 2 is a perspective view illustrating a plurality of display modules according to the present embodiment;
FIG. 3 is a cross-sectional view illustrating a space filled with filler between adjacent display modules illustrated in FIG. 2;
FIG. 4 is a perspective view illustrating a space filled with filler between adjacent display modules as illustrated in FIG. 2;
FIG. 5 is a diagram illustrating a manufacturing process of a display device according to the present embodiment;
FIG. 6 is a cross-sectional view illustrating a plurality of display modules illustrated in FIG. 5; and
FIG. 7 is a diagram illustrating a method for manufacturing a display device according to the present embodiment.

### [Best Mode]

Hereinafter, embodiments related to the present disclosure will be described in more detail with reference to the drawings. The suffixes "interface," "module," and "part" used for components in the following description are given or used interchangeably only for the convenience of writing the specification, and do not have distinct meanings or roles in themselves.

The display device according to an embodiment of the present disclosure is, for example, an intelligent display device that adds a computer support function to a broadcast reception function, and while remaining faithful to the broadcast reception function, the display device can have an Internet function or the like and can have a more convenient interface such as a manual input device, a touch screen, or a space remote control. In addition, with the support of a wired or wireless Internet function, it can be accessed to the Internet and a computer, and can also perform functions such as e-mail, web browsing, banking, or games. A standardized general-purpose OS can be used for these various functions.

Accordingly, the display device described in the present disclosure can perform various user-friendly functions, for example, since various applications can be freely added or deleted on a general-purpose OS kernel. More specifically, the display device can be, for example, a network TV, an HBBTV, a smart TV, an LED TV, an OLED TV, or the like, and in some cases, can also be applied to a smartphone.

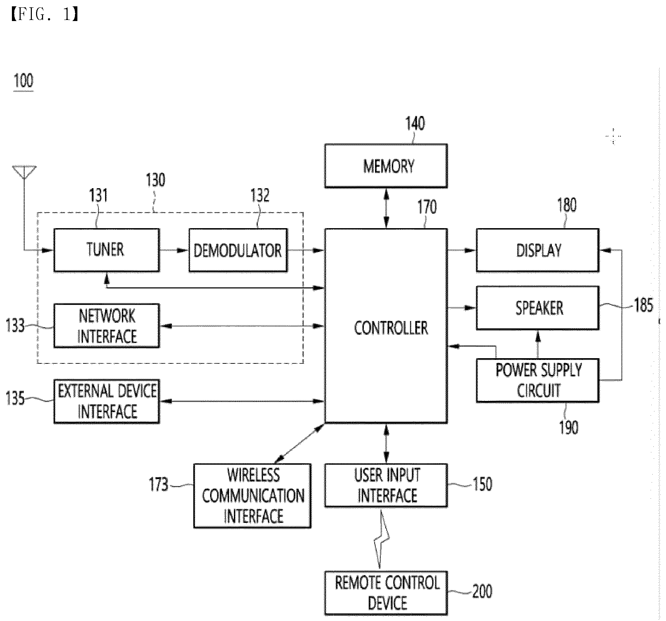

FIG. 1 is a block diagram illustrating the configuration of a display device according to the present embodiment.

Referring to FIG. 1, the display device 100 may comprise a broadcast receiving part 130, an external device interface 135, a memory 140, a user input interface 150, a controller 170, a wireless communication interface 173, a display 180, a speaker 185, and a power supply circuit 190.

The broadcast receiving part 130 may comprise a tuner 131, a demodulator 132, and a network interface 133.

The tuner 131 can select a specific broadcast channel according to a channel selection command. The tuner 131 can receive a broadcast signal for the selected specific broadcast channel.

A demodulator 132 can separate a received broadcast signal into a video signal, an audio signal, and a data signal related to a broadcast program, and can restore the separated video signal, audio signal, and data signal into a form that can be output.

The external device interface 135 can receive an application or a list of applications within an adjacent external device and transmit them to the controller 170 or memory 140.

The external device interface 135 can provide a connection path between the display device 100 and the external device. The external device interface 135 can receive one or more of images and audio output from an external device connected wirelessly or wiredly to the display device 100 and transmit them to the controller 170. The external device interface 135 can comprise a plurality of external input terminals. The plurality of external input terminals can comprise an RGB terminal, one or more HDMI (High Definition Multimedia Interface) terminals, and a component terminal.

An image signal of an external device input through an external device interface 135 can be output through a display 180. A voice signal of an external device input through an external device interface 135 can be output through a speaker 185.

An external device that can be connected to the external device interface 135 may be any one of a set-top box, a Blu-ray player, a DVD player, a game console, a sound bar, a smartphone, a PC, a USB memory, and a home theater, but these are only examples.

The network interface 133 can provide an interface for connecting the display device 100 to a wired/wireless network comprising the Internet. The network interface 133 can transmit or receive data to or from another user or another electronic device through the accessed network or another network linked to the accessed network.

In addition, some of the content data stored in the display device 100 can be transmitted to a selected user or electronic device among other users or other electronic devices pre-registered in the display device 100.

The network interface 133 can access a predetermined web page through an accessed network or another network linked to the accessed network. In other words, the network interface can access a predetermined web page through a network and transmit or receive data with the corresponding server.

In addition, the network interface 133 can receive content or data provided by a content provider or a network operator. In other words, the network interface 133 can receive content such as movies, advertisements, games, VOD, broadcast signals, or the like, and information related thereto provided from a content provider or a network provider through a network.

Additionally, the network interface 133 can receive firmware update information and update files provided by the network operato, and transmit data to the Internet or content provider or network operator.

The network interface 133 can select and receive a desired application from among applications open to the public via a network.

The memory 140 stores programs for each signal processing and control within the controller 170 and can store signal processed images, voices, or data signals.

In addition, the memory 140 may perform a function for temporary storage of image, voice, or data signals input from an external device interface 135 or a network interface 133, and may also store information about a specific image through a channel memory function.

The memory 140 can store an application or a list of applications input from an external device interface 135 or a network interface 133.

The display device 100 can play content files (moving image files, still image files, music files, document files, application files, or the like) stored in the memory 140 and provide them to the user.

The user input interface 150 can transmit a signal input by the user to the controller 170, or transmit a signal from the controller 170 to the user. For example, the user input interface 150 can receive and process control signals such as power on/off, channel selection, and screen setting from the remote control device 200 according to various communication methods such as Bluetooth, Ultra Wideband (WB), ZigBee, RF (Radio Frequency) communication, or infrared (IR) communication, or process control signals from the controller 170 to be transmitted to the remote control device 200.

In addition, the user input interface 150 can transmit control signals input from local keys (not illustrated) such as a power key, channel key, volume key, and setting key to the controller 170.

An image signal processed by the controller 170 may be input to the display 180 and displayed as an image corresponding to the image signal. In addition, an image signal processed by the controller 170 may be input to an external output device through an external device interface 135.

The voice signal processed in the controller 170 can be output as audio to the speaker 185. Additionally, the voice signal processed in the controller 170 can be input to an external output device through the external device interface 135.

In addition, the controller 170 can control the overall operation within the display device 100.

In addition, the controller 170 can control the display device 100 by a user command or an internal program input through the user input interface 150, and can access to a network to allow the user to download a desired application or application list into the display device 100.

The controller 170 enables the user-selected channel information or the like to be output through the display 180 or speaker 185 together with the processed image or audio signal.

In addition, the controller 170 allows an image signal or voice signal from an external device, for example, a camera or camcorder, input through the external device interface 135 to be output through the display 180 or speaker 185 in accordance with an external device image playback command received through the user input interface 150.

Meanwhile, the controller 170 can control the display 180 to display an image, and for example, can control the display 180 to display a broadcast image input through the tuner 131, an external input image input through the external device interface 135, an image input through the network interface part, or an image stored in the memory 140. In this case, the image displayed on the display 180 can be a still image or a moving image, and can be a 2D image or a 3D image.

In addition, the controller 170 can control the playback of content stored in the display device 100, received broadcast content, or external input content input from the outside, and the content can be in various forms such as broadcast images, external input images, audio files, still images, accessed web screens, and document files.

The wireless communication interface 173 can perform communication with an external device through wired or wireless communication. The wireless communication interface 173 can perform short range communication with an external device. To this end, the wireless communication interface 173 can support short range communication by using at least one of Bluetooth^{™}, RFID (Radio Frequency Identification), Infrared Data Association (IrDA), UWB (Ultra Wideband), ZigBee, NFC (Near Field Communication), Wi-Fi (Wireless-Fidelity), Wi-Fi Direct, and Wireless USB (Wireless Universal Serial Bus) technologies. Such a wireless communication interface 173 can support wireless communication between the display device 100 and a wireless communication system, between the display device 100 and another display device 100, or between the display device 100 and a network where the display device 100 (or an external server) is located via a wireless area network. The wireless area network can be a wireless personal area network.

Here, the other display device 100 may be a wearable device (e.g., a smartwatch, smart glass, HMD (head mounted display)), a mobile terminal such as a smart phone, etc., which can exchange data with (or be linked to) the display device 100 according to the present disclosure. The wireless communication interface 173 may detect (or recognize) a wearable device capable of communication around the display device 100.

Furthermore, if the detected wearable device is a device authenticated to communicate with the display device 100 according to the present disclosure, the controller 170 can transmit at least a part of the data processed in the display device 100 to the wearable device via the wireless communication interface 173. Accordingly, a user of the wearable device can use the data processed in the display device 100 via the wearable device.

The display 180 can generate a driving signal by converting an image signal, data signal, OSD signal processed by the controller 170 or an image signal, data signal, or the like received from an external device interface 135 into R, G, and B signals, respectively.

Meanwhile, since the display device 100 illustrated in FIG. 1 is only an embodiment of the present disclosure, some of the illustrated components may be integrated, added, or omitted according to the specifications of the display device 100 actually implemented.

In other words, two or more components may be combined into one component, or one component may be divided into two or more components, as needed. In addition, the functions performed by each block are intended to explain an embodiment of the present disclosure, and the specific operations or devices thereof do not limit the scope of the present disclosure.

According to another embodiment of the present disclosure, unlike as illustrated in FIG. 1, the display device 100 may receive and play back an image through a network interface 133 or an external device interface 135 without having a tuner 131 and a demodulator 132.

For example, the display device 100 may be implemented separately as an image processing device, such as a set-top box for receiving contents according to broadcast signals or various network services, and a content playback device for playing contents input from the image processing device.

In this case, a method for operating the display device according to the embodiment of the present disclosure to be described below may be performed by any one of the display device 100 described with reference to FIG. 1, as well as an image processing device such as the separated set-top box, or a content playback device having a display 180 and an audio output part 185.

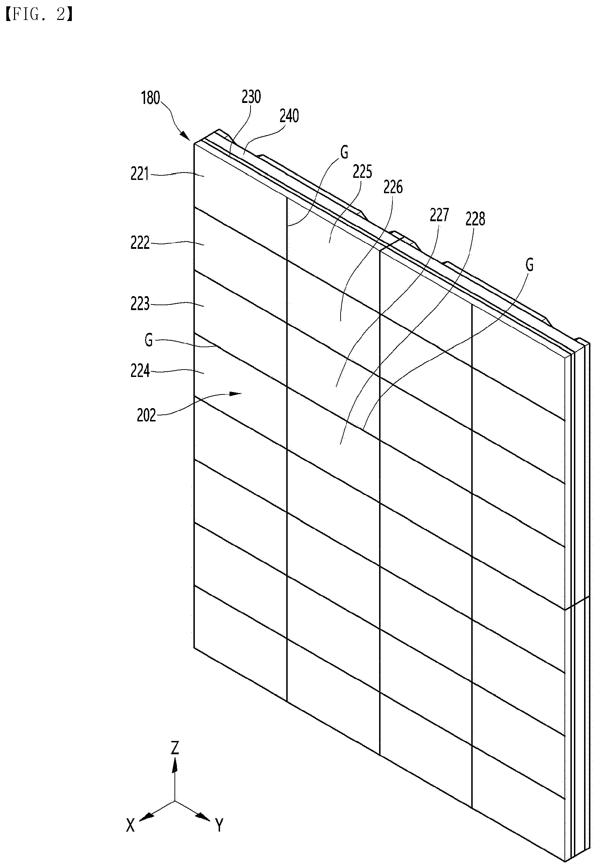

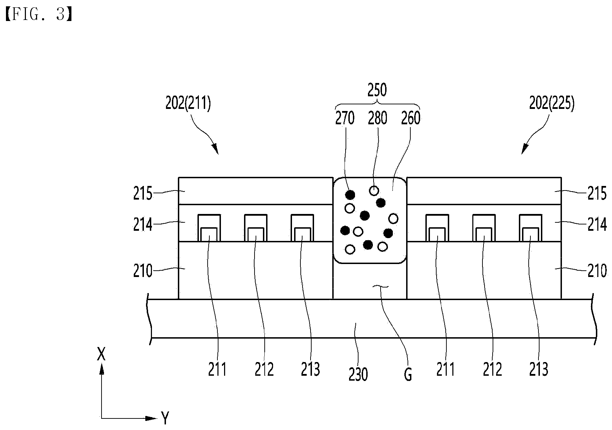

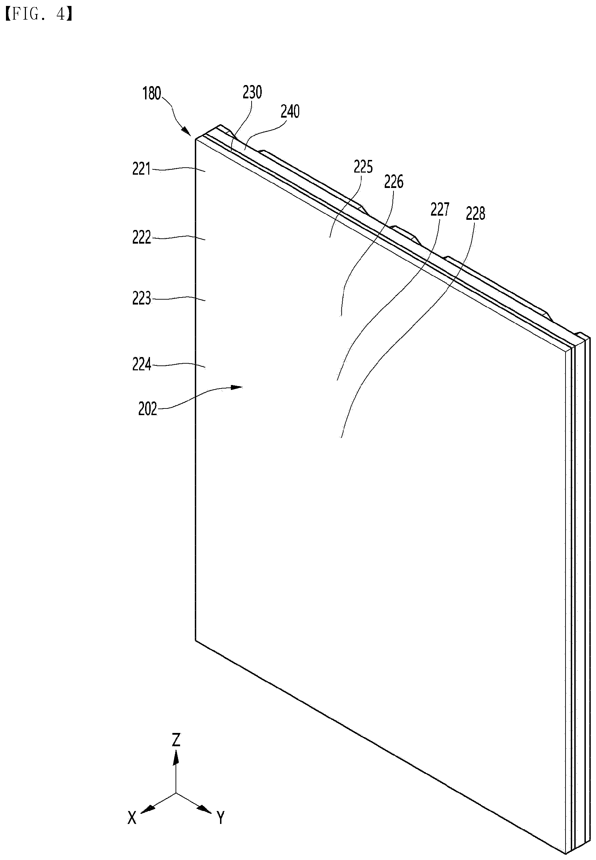

FIG. 2 is a perspective view illustrating a plurality of display modules according to the present embodiment, FIG. 3 is a cross-sectional view illustrating a space filled with filler between adjacent display modules illustrated in FIG. 2, and FIG. 4 is a perspective view illustrating a space filled with filler between adjacent display modules as illustrated in FIG. 2;

A display device 100, particularly a display 180, may comprise a display module 202.

The display module 202 may comprise a substrate 210, a plurality of LED chips 211, 212, 213, a coating layer 214, and an optical film 215.

A circuit connected to a plurality of LED chips 211, 212, 213 may be provided on the substrate 210. The substrate 210 may be a printed circuit board (PCB).

A plurality of LED chips 211, 212, 213 may be disposed on a substrate 210. The plurality of LED chips 211, 212, 213 may comprise an R LED chip 211, a G LED chip 212, and a B LED chip 213.

A plurality of the R LED chips 211, G LED chips 212, and B LED chips 213 may be provided in multiples on the substrate 210, respectively.

The coating layer 214 can cover a plurality of LED chips 211, 212, 213 and can cover a surface of the substrate 210 on which the LED chips 211, 212, 213 are disposed. The coating layer 214 can support the LED chips 211, 212, 213 and protect the LED chips 211, 212, 213 and the substrate 210.

The optical film 215 can cover the coating layer 214. The optical film 215 can be disposed on the front surface of the coating layer 214 and can protect the coating layer 214.

A plurality of display modules 202 may be provided.

A plurality of display modules 221, 222, 223, 224, 225, 226, 227, 228 can be disposed in a vertical direction Z and a left and right direction Y, and the plurality of display modules 221, 222, 223, 224, 225, 226, 227, 228 can provide one screen together or can provide a plurality of screens by dividing them.

A plurality of display modules 221, 222, 223, 224, 225, 226, 227, 228 can be formed with the same structure, and the common configuration is described as a display module 202.

The display device 100, particularly the display 180, may further comprise a module holder 230 in which a plurality of display modules 202 are mounted, and a cabinet 240 in which the module holder 230 is mounted.

The module holder 230 may be formed larger than the display module 202, and a plurality of display modules 202 may be disposed on the front surface of the module holder 230.

The module holder 230 can be disposed on the front surface of the cabinet 240, or can be disposed inside the cabinet 240.

The cabinet 240 can support the module holder 230 and protect the module holder 230.

It is preferable that a plurality of display modules 202 be disposed on one plane without steps, but minute steps between modules may occur due to errors in the manufacturing process or during the assembly process.

The step between modules may cause a bright line to appear when the display module 202 is turned on due to the step, and may cause a white line (i.e., a white colored line) due to the protrusion of a specific display module when the display module 202 is turned off, which may reduce the sense of unity.

It is preferable that the plurality of display modules 202 be disposed so that the gap G between adjacent display modules is minimized, but a slight gap G may exist between adjacent display modules.

The gap G may be equal to or larger than a certain size (for example, 40 µm), in which case, when the display module 202 is turned on, a dark line may occur due to the light-off, and when the display module 202 is turned off, a white line may occur due to optical distortion (that is, scattering and refractive index deviation) in the gap G.

It is desirable for the display device 100 to minimize bright lines and white lines, and the display device 100, particularly the display 180, may further comprise a filler 250 filled in the gap G between adjacent display modules.

The filler 250 may comprise a binder resin 260, a transmittance-controlling particle 270, and a refractive index-controlling particle 280.

Examples of the binder resin 260 may comprise at least one of organic polysiloxan, polysiloxan block copolymer, polyester urethane, and high viscosity wax.

The viscosity of the binder resin 260 can be 50,000 cPs to 300,000 cPs.

Examples of the transmittance-controlling particles 270 may comprise carbon black for controlling transmittance and color, and color controlling particles (color pigments).

As examples of color-controlling particles, cobalt, titanium dioxide (TiO2), or the like can be applied.

The transmittance-controlling particles 270 can match colors between display modules 202 and absorb scattered light.

The refractive index-controlling particles 280 may comprise silica and polystyrene beads, as an example.

The size of the silica may be from 5 nm to 10 nm, and the size of the polystyrene beads may be from 10 nm to 90 nm.

Refractive index-controlling particles 280 can prevent optical distortion due to refractive index.

The content ratio of the binder resin 260 may be 30% to 88%, the content ratio of the transmittance controlling particles 270 may be 2% to 30%, and the content ratio of the refractive index-controlling particles 280 may be 10% to 40%.

When dispersed, each particle can have a uniform dispersion of polystyrene beads 3.0 or less.

After mounting the plurality of display modules 202, the filler 250 can be filled in the gap G of the plurality of display modules 202 and can be cured in the gap G.

The filler 250 can absorb light scattered from the gap G and provide an optical sense of identity between the gap G and the display module 202.

The filler 250 can provide a the sense of unity to the plurality of display modules 202 as if the plurality of display modules 202 were one display module, as illustrated in FIG. 4.

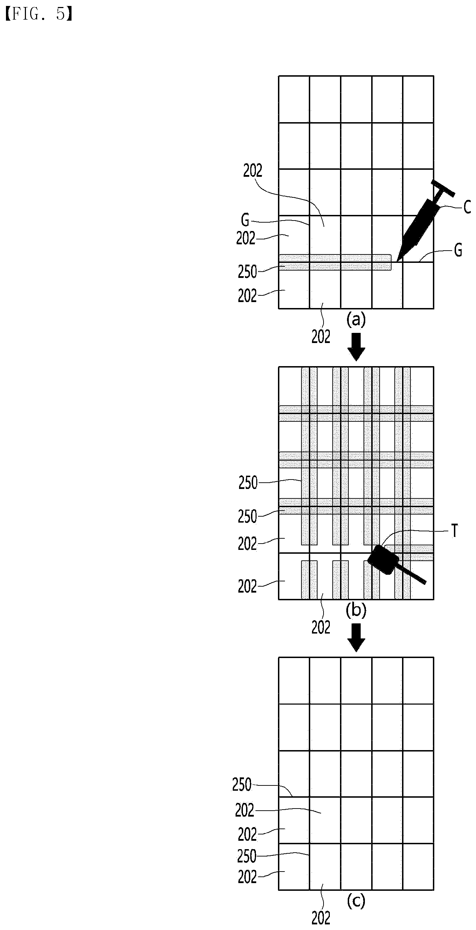

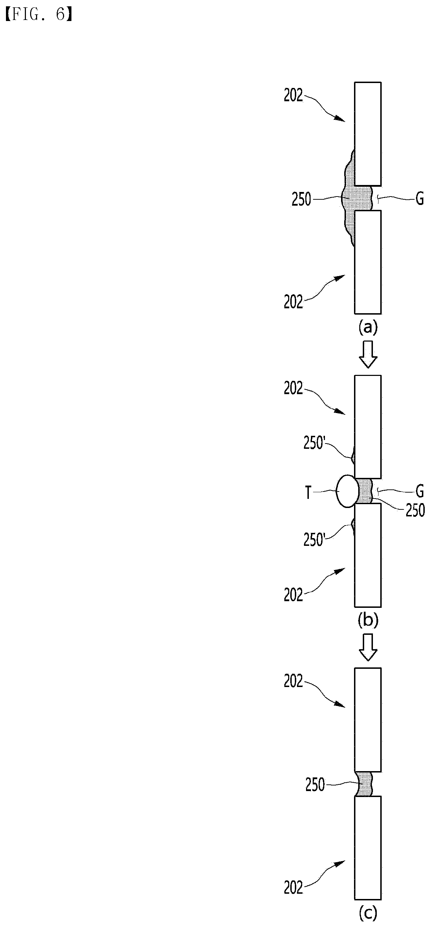

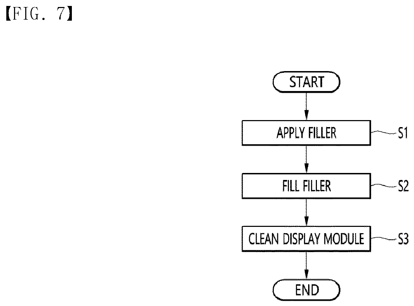

FIG. 5 is a diagram illustrating a manufacturing process of a display device according to the present embodiment, FIG. 6 is a cross-sectional view illustrating a plurality of display modules illustrated in FIG. 5, and FIG. 7 is a diagram illustrating a method for manufacturing a display device according to the present embodiment.

A method for manufacturing a display device may comprise a step of applying a filler 250 between adjacent display modules 202 (S1, hereinafter referred to as an applying step), a step of filling the filler 250 using a tool T (S2, hereinafter referred to as a filling step), and a step of wiping off the filler 250' from the surface of adjacent display modules 202 (S3, hereinafter referred to as a cleaning step).

During the application step, the filler 250 can be applied to the gap G between adjacent display modules 202, as illustrated in FIG. 5 (a).

The filler 250 may comprise a binder resin 260, a transmittance-controlling particle 270, and a refractive index-controlling particle 280, as illustrated in FIG. 3.

During the application step, a worker or robot can apply filler 250 to the gap G using an application mechanism C.

The application mechanism C may comprise a cartridge containing a filler 250 therein and a nozzle disposed at the outlet of the cartridge.

Cartridges can be manufactured and applied in different sizes according to capacity and can be configured to be suitable for mass production.

It is preferable that the nozzle be configured to inject filler 250 between assembled display modules 202.

The gap G may be smaller than the outlet of the nozzle, and a worker or robot may apply filler 250 to the gap and surrounding area of the display module G, as illustrated in FIG. 6 (a) and FIG. 7 (a).

A part of the filler 250 may penetrate the gap G, and the remainder of the filler 250 may not flow into the gap G and remain on the front surface of the display module 202.

The filling step (S2) may be a step of pushing the fillerl 250 for which the application step (S1) has been completed into the gap G, or may be a step of filling the gap G with the filling material 250.

During the filling step (S2), the worker or robot can move the tool T along the gap G.

In the application step (S1) of the filler 250, a part that is not filled in the gap G can be moved to the gap G by being pushed by the tool T in Fig. 6 (b) and Fig. 7 (b).

By the filling step (S2), the gap G can be minimized, and the maximum amount of filler 250 can be filled into the gap G.

During the charging step (S2), the remainder 250' of the filler 250 may remain on the front surface of the display module 202, as illustrated in FIG. 7 (b).

During the cleaning step (S3), a worker, a robot, or the like can clean the surface of the filler 250' of the surfaces of adjacent display modules 202 with a cleaning member, and the filler 250 filled in the gap G can be cured (e.g., naturally cured).

As described above, when the application step (S1), the filling step (S2), and the cleaning step (S3) are completed, the display device can have the gap G of the display modules 202 hidden by the filler 250, and the display device can secure a sense of unity.

The above description is merely an example of the technical idea of the present disclosure, and those skilled in the art will appreciate that various modifications and variations may be made without departing from the essential characteristics of the present disclosure.

Accordingly, the embodiments disclosed in the present disclosure are not intended to limit the technical idea of the present disclosure but to explain it, and the scope of the technical idea of the present disclosure is not limited by these embodiments.

The scope of protection of the present disclosure should be interpreted by the claims below, and all technical ideas within a scope equivalent thereto should be interpreted as being comprised in the scope of the rights of the present disclosure.

## Claims

1. A display device comprising:
a plurality of display modules disposed in a vertical direction and a left and right direction; and
a filler filled between adjacent display modules,
wherein the filler comprises a binder resin, transmittance-controlling particles, and refractive index-controlling particles.

2. The display device of claim 1,
wherein the binder resin comprises at least one of organic polysiloxane, polysiloxane block copolymer, polyester urethane, or wax.

3. The display device of claim 1,
wherein a viscosity of the binder resin is 50,000 cPs to 300,000 cPs.

4. The display device of claim 1,
wherein the transmittance-controlling particles comprise carbon black and color controlling particles (color pigments).

5. The display device of claim 1,
wherein the refractive index-controlling particles comprise silica and polystyrene beads.

6. The display device of claim 1,
wherein a size of the silica is 5 nm to 10 nm, and
wherein a size of the polystyrene beads is 10 nm to 90 nm.

7. The display device of claim 1,
wherein a content ratio of the transmittance-controlling particles is 2% to 30%, and
wherein a content ratio of the refractive index-controlling particles is 10% to 40%.

8. The display device of claim 1,
wherein the display module comprises:
a substrate;
a plurality of LED chips disposed on the substrate;
a coating layer covering the plurality of LED chips; and
an optical film covering the coating layer.

9. A method for manufacturing display device, comprising:
applying a filler between adjacent display modules;
filling with the filler using a tool; and
wiping off the filler from surfaces of the adjacent display modules; and
wherein the filler comprises a binder resin, transmittance-controlling particles, and refractive index-controlling particles.

10. A display device of claim 9,
wherein the binder resin comprises at least one of organic polysiloxane, polysiloxane block copolymer, polyester urethane, or wax.

11. A display device of claim 9,
wherein the transmittance-controlling particles comprise carbon black and color controlling particles (color pigments).

12. A display device of claim 9,
wherein the refractive index-controlling particles comprise silica and polystyrene beads.
